(19) Europäisches Patentamt
European Patent Office
Office européen des brevets

(11) EP 1 855 156 A1

(12) EUROPEAN PATENT APPLICATION
published in accordance with Art. 158(3) EPC

(43) Date of publication:
14.11.2007 Bulletin 2007/46

(51) Int Cl.:
$G02F\ 2/02^{(2006.01)}$     $H01S\ 1/02^{(2006.01)}$

(21) Application number: 06715160.5

(86) International application number:
PCT/JP2006/304077

(22) Date of filing: 03.03.2006

(87) International publication number:
WO 2006/093265 (08.09.2006 Gazette 2006/36)

(84) Designated Contracting States:
DE FR GB

(30) Priority: 03.03.2005 JP 2005059520

(71) Applicant: National Institute of Information and Communications Technology Independant Administrative Agency
Koganei-shi,
Tokyo 184-8795 (JP)

(72) Inventors:
• NAKAYAMA, Masaaki
Nara, 6391061 (JP)
• MIZOGUCHI, Kohji
Osaka, 573114 (JP)
• SAKAI, Kiyomi
Tokyo, 1848795 (JP)
• SAITO, Shingo
Tokyo, 1848795 (JP)

(74) Representative: Chettle, Adrian John
Withers & Rogers LLP
Goldings House,
2 Hays Lane
London SE1 2HW (GB)

(54) METHOD FOR GENERATING TERAHERTZ ELECTROMAGNETIC WAVE BY COHERENT PHONON

(57) In a method for generating a terahertz electromagnetic wave by using coherent phonons in a quantum structure, high density of coherent phonons acting as a radiation source of the terahertz electromagnetic wave are obtained by exciting the inter-band transitions in a quantum structure under the condition that the energy difference between two inter-band transitions in the quantum structure is resonated with the energy of the coherent phonons, and the terahertz electromagnetic wave is generated by the oscillatory polarizations of the coherent phonons. High density of coherent phonons may be created through the elementary excitation generated by using instantaneous laser pulses. A quantum well structure is effective as the quantum structure, and a scattering process of coherent phonon may be suppressed by confining coherent LO phonons in a well layer. Under the condition that the difference of energies between the heavy-hole and light-hole exitons in a quatum well structure agrees with the energy of LO phonons and both the exitons are created simultaneously, high density of coherent phonons may be generated. With this method, a terahertz electromagnetic wave can be effectively and strongly emitted from the coherentphonons.

fig.10

## Description

TECHNICAL FIELD

The present invention relates to a method for generating high intensity terahertz electromagnetic waves efficiently by using coherent phonons.

BACKGROUND ART

A research for a terahertz electromagnetic wave is a relatively new field which started from a time at which it became possible to generate and detect the terahertz electromagnetic waves by the development of a laser technology in early 1990s. An initial research mainly related to a terahertz electromagnetic waves emitted from printed photoconductive antennas and semiconductor surfaces when a pulse laser was radiated.
(Non-Patent Documents 1, 2).
Non-Patent Document 1:
P.R. Smith and D.H. Auston, IEEE J. Quantum Electron. 24, 255 (1988) Non-Patent Document 2:

X.-C. Zhang, B.B. Hu, J.T. Darrow and D.H. Auston, Appl. Phys. Lett. 56, 1011 (1990)

Recently, terahertz electromagnetic waves emitted from coherent longitudinal optical (LO) phonons have been also observed, and researches for the physical properties and the applications of the terahertz electromagnetic waves have been actively carried out.
(Non-Patent Document 3, 4, 5, 6)
Non-Patent Document 3:
T.Dekorsy, H. Auer, H.J. Bakker.H.G. Roskos, and H. Kurz, Phys. Rev. B53, 4005 (1996) Non-Patent Document 4:
M. Tani, R. Fukasawa, H. Abe, S. Matsuura, S.Nakashima and K. Sakai. J. Appl. Phys. 83, 2473 (1998)
Non-Patent Document 5:
A. Leitenstorfer, S.Hunsche, J. Shah, M.C. Nuss and W.H. Knox, Phys. Rev. Lett.82.5140 (1999)
Non-Patent Document 6:
Y.C. Shen, P.C. Upadhya, H.E. Beere, A.G. Davies, I.S, Gregory, C. Baker, W.R. Tribe, M.J. Evans and E. H. Linfield, Appl. Phys. Lett. 85, 164 (2004)
In the emission mechanism of terahertz electromagnetic waves from coherent LO phonons in these documents, the terahertz electromagnetic wave is emitted by the breaking of translational symmetry of coherent LO phonons around a sumple surface.
However, since the terahertz electromagnetic waves from the coherent LO phonons in bluk semiconductors have very weak amplitudes, it is difficult to apply the terahertz electromagnetic waves to a terahertz technology for communication, spectroscopy, imaging, and so on.
Thus, there is a requirement to generate high intensity and high coherence terahertz electromagnetic waves from coherent phonons.
For example, in a method to generate terahertz electromagnetic waves by a multiple quantum well cascade laser, cooling to a liquid nitrogen temperature or less is required. Further, in a method of generating terahertz electromagnetic waves by radiating a short pulse laser to semiconductor bulk crystal, a resonant increase of the terahertz electromagnetic waves is not observed.
Thus, conventional arts do not disclose any method of enhancing terahertz electromagnetic waves generated by coherent phonons.

DISCLOSURE OF THE INVENTION

Accordingly, an object of the present invention is to provide a method to generate intense terahertz electromagnetic waves effectively based on coherent phonons.
To solve the above problems, the present invention is achieved based on such a design that the difference of the energies between two inter-band transitions in a semiconductor quantum structure is resonated with the energy of coherent phonons and the energy of the pulse laser is tuned to the inter-band transitions in the semiconductor quantum structure, so that high density of coherent phonons can be generated as a radiation source.
It is considered, paying attention to GaAs/AlAs multiple quantum well structure, that since terahertz electromagnetic waves are emitted by the frequency of polarizations caused by LO phonons confined in respective well layers, the region in which the terahertz electromagnetic wave is emitted is increased as compared with a thin film and a bulk crystal. With this arrangement, the intensity of the terahertz electromagnetic wave emitted from coherent LO phonons is increased. Further, in the multiple quantum well structure, since the coherent LO phonons are confined in the respective well layers, a scattering process of the coherent LO phonon is suppressed, and a terahertz electromagnetic wave with very high coherency is generated.

Thus, it is intended to obtain an intense terahertz electromagnetic wave with a high coherency from coherent LO phonons by using the GaAs/AIAs multiple quantum well structure.

The energies of the inter-band transitions and the electron and hole states in a semiconductor quantum structure are controlled by selectively designing the material and the structure of the semiconductor quantum structure as well as the energy difference between two inter-band transitions is resonated with the energy of the coherent phonons. Thereafter, the coherent phonons are strongly created through elementary excitation generated by using instantaneous laser pulses, thereby the terahertz electromagnetic wave can be increased.

A method of the present invention for generating a terahertz electromagnetic wave by using coherent LO phonons in a quantum structure is characterized by obtaining high density of coherent LO phonons acting as a radiation source of the terahertz electromagnetic wave under the condition that the energy difference between two inter-band transitions is resonated with the energy of the coherent phonons and the energy of the pulse laser is tuned to the inter-band transitions in the quantum structure, and by generating the terahertz electromagnetic wave caused by the oscillatory polarizations of the coherent confined LO phonons.

Here, the coherent phonons may be created through elementary excitation generated by using instantaneous laser pulses under the condition that the energy difference between two inter-band transitions in the quantum structure is resonated with the energy of the coherent phonons.

A quantum well structure may be effective as the quantum structure, and a scattering process may be suppressed by confining the coherent LO phonons in a well layer.

Heavy hole (HH) and light hole (LH) exitons may be created simultaneously, and the difference of energies between HH and LH excitons may be caused to agree with the energy of the LO phonons.

The quantum structure may be a single quantum well or a multiple quantum well.

Further, a superlattice or a self-forming quantum dot may be also used as the quantum structure.

The quantum structure may be composed of a semiconductor in production for the convenience in use.

A GaAs/AIAs multiple quantum well structure is exemplified as the semiconductor.

Further, the semiconductor GaAs/AIAs multiple quantum well structure, which is composed of about 50 periods of (GaAs)35/(AIAs)35 components (35 means the number of constituted atom layers), may be effectively used.

The about 50 periods of the (GaAs)35/(AIAs)35 components may be epitaxially grown on a GaAs (100) substrate or the like relatively easily.

The quantum structure may be composed of dielectric, semi-metal, or an organic substance.

EFFECT OF THE INVENTION

According to the present invention, intense terahertz electromagnetic waves can be effectively generated from coherent phonons by resonant enhancement even at a relatively high temperature.

BRIEF DESCRIPTION OF THE DRAWINGS

Fig. 1, which shows a band structure near to a surface of a semiconductor, is a schematic view showing a surface potential of an n-type semiconductor;

Fig. 2 which shows a band structure near to a surface of a semiconductor, is a schematic view showing a surface potential of a p-type semiconductor;

Fig. 3 is a schematic view showing a transient current obtained by a surface electric field;

Fig. 4 is a schematic view showing photo-Dember effect on a semiconductor surface;

Fig. 5 shows time-domain signals of terahertz electromagnetic waves in a (35, 35)50 MQW and GaAs thin films;

Fig. 6 shows the spectra obtained by Fourier-transforming the time-domain signals of terahertz electromagnetic waves in the (35, 35)50 MQW and a GaAs thin film;

Fig. 7 shows time-domain signals of terahertz electromagnetic waves when excitation power is changed in the (35, 35)50 MQW;

Fig. 8 is a graph showing Fourier transformed spectra of the signals of terahertz electromagnetic waves when excitation power is changed in the (35, 35)50 MQW;

Fig. 9 is a graph showing the signals of terahertz electromagnetic waves when the excitation energy is changed in the (35, 35)50 MQW;

Fig. 10 is a graph showing the excitation energy dependence of the maximum amplitude of the terahertz electromagnetic wave from the coherent LO phonon;

Fig. 11 is a graph showing the signals of terahertz electromagnetic waves obtained in the (35, 35)50 MQW and a (35, 35)30 MQW;

Fig. 12 is a graph showing the amplitude intensities of the signals in Fig. 7 when they are plotted as the function of excitation intensity;

Fig. 13 is a graph in which the signals of emitted terahertz electromagnetic waves are plotted;

Fig. 14 is a graph in which the amplitudes of the terahertz electromagnetic waves are plotted as the fucntion of exciting light intensity;

Fig. 15 is a graph showing the temperature dependence of terahertz electromagnetic waves observed in a GaAs thin film;

Fig. 16 is a graph showing the amplitudes of the terahertz electromagnetic waves at respective temperatures in Fig. 15;

Fig. 17 is a graph showing the temperature dependence of the terahertz electromagnetic waves observed in the (35, 35)50 MQW;

Fig. 18 is a graph in which amplitudes at respective temperatures are plotted as a function of exciting light intensity; and

Fig. 19 is a graph showing the output of a terahertz electromagnetic wave observed in the (35, 35)50 MQW.

BEST MODE FOR CARRYING OUT THE INVENTION

An embodiment of the present invention will be explained below based on the drawings.

A typical mechanism in which a terahertz electromagnetic wave is emitted from a semiconductor surface is as described below.

A leading emission mechanism of a terahertz-wave from a semiconductor surface carried out by conventionally proposed femtosecond laser pulse excitation is classified into two types. One of the types is a model in which a terahertz electromagnetic wave is generated by radiating a femtosecond pulse laser without generating photo-excited carriers in a specimen. The model is known as the optical rectification effect or difference frequency generation. The other type is a model for generating a terahertz electromagnetic wave by creating photo-excited carriers in a specimen by radiating a femtosecond pulse laser to the specimen. The photo-excited carriers is accelerated by an electric field in the specimen or scattering and generates a transient current. A terahertz electromagnetic wave is generated by the transient current. This model is known as a transient current effect.

This model is further divided into two sub-models depending on a factor by which the transient current is generated. One of the sub-models is a "transient current model by a surface electric field" in which a transient current is generated by an accelerated light exciting carriers on the surface electric field of a semiconductor surface, and the other one of them is a "photo-Dember model" in which a transient current is generated by the scattering current of photo-excited carriers.

Since an electromagnetic wave emitted from a semiconductor surface in the embodiment is entirely emitted by actual excitation, the transient current effect will be explained here.

It is known that since periodicity is breaking on a semiconductor surface different from the inside of bulk crystal, the semiconductor surface takes an energy state different from the inside of crystal. When the energy state is determined, a Fermi level plays an important role. Although the Fermi level of a semiconductor surface has approximately an inherent state, a Fermi level in the inside of crystal is determined by the amount of the electrons and the holes thereof. In an equilibrium state, since the Fermi level of the surface and that of the inside of crystal have the same value, carriers (electrons and holes) migrate between a surface state and the level of the inside of crystal in the vicinity of a surface. A band structure is bent by the migration in the vicinity of the surface, thereby a surface electric field is generated.

At the time, when a lot of carriers are trapped to a surface level, a depletion layer having a less amount of carriers is formed in the vicinity of the surface, and further an acumulation layer having a large amount of carriers and an inversion layer in which a small amount of carriers gathers on the surface may be formed.

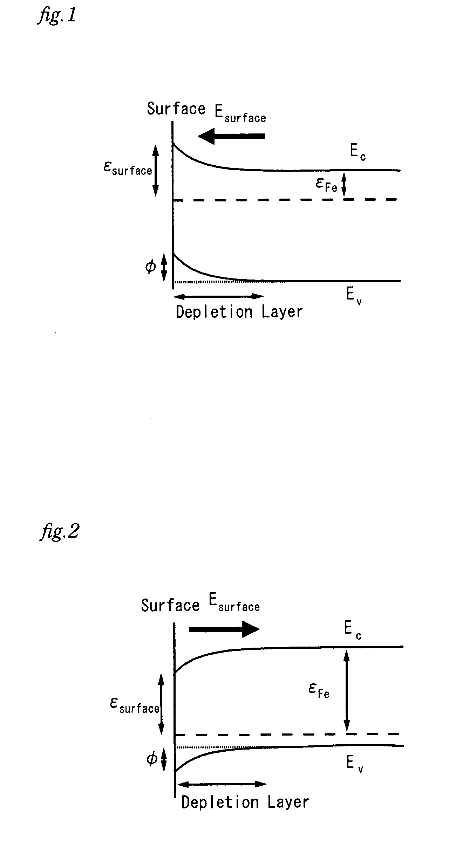

Figs. 1 and 2 are schematic views showing a band structure in the vicinity of a surface of a semiconductor surface, wherein Fig. 1 is a schematic view of the surface potential of an n-type semiconductor, and Fig. 2 is a schematic view of the surface potential of a p-type semiconductor. GaAs is exemplified as an example of a semiconductor.

In general, in an n-type GaAs, a band is bent upward, and a surface electric field $E_{surface}$ directs toward a sample surface from the inside of a specimen as shown in Fig. 1. In contrast, in a p-type GaAs, the direction in which a band is bent and the direction of a surface electric field are opposite to those of the n-type semiconductor as shown in Fig. 2.

The direction in which the band is bent and the amount of band offset are determined by the positional relation between a surface Fermi level and the Fermi level of the inside of crystal. In GaAs, the surface Fermi level is located at a position 0.5 eV higher than the upper portion of a valence band. Then, in n-type GaAs, the Fermi level in the interior of crystal is located near to a conduction band. The band is bent upward so that they are located at the same position.

Accordingly, the band offset ($\phi$) corresponds to the difference between the Fermi level ($\varepsilon_{fermi}$) in the interior of crystal and the surface Fermi level ($\varepsilon_{surface}$).

$$\phi = \varepsilon_{fermi} - \varepsilon_{surface}$$

Further, in a p-type, since the Fermi level in the interior of crystal is located in the vicinity of a valence band, a band is bent downward.

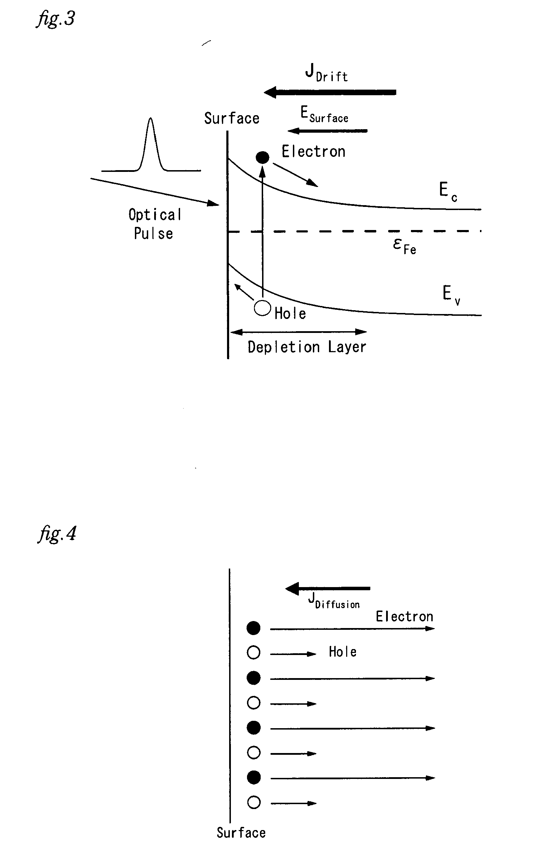

Fig. 3 is a schematic view showing a transient current effect obtained from a surface electric field.

When a femtosecond pulse laser is radiated to a semiconductor surface having the surface electric field, photo-excite carriers (electrons and holes) are created. Then, the electrons and the holes of the created photo-excited carriers are accelerated in opposite directions by the surface electric field, thereby a drift current is generated. It is the transient current model making use of the surface electric field to assume that a terahertz wave is emitted by the generation of the drift current.

The electric field amplitude (ETHz) of the terahertz wave emitted by the transient current model making use of the surface electric field is shown by the following equation
(Non-Patent Document 7).
Non-Patent Document 7:

X.-C. Zhang, and D.H. Auston, J. Appl. Phys. 71, 326 (1992)

[Equation 1]

$$E_{\mathrm{THz}}(t) \propto \frac{\partial \boldsymbol{J}(t)}{\partial t} \propto \frac{d}{dt} \int_0^w E_d(z) e^{-\alpha z} dz \int_{-\infty}^t \mu(t-t') \int_{-\infty}^{t'} e^{-(t'-t'')/\tau_0} \boldsymbol{I}_{\mathrm{op}}(t'') dt' dt''$$

Here, J is the photo current, z is the distance from the surface, $\alpha$ is the absorption coefficient, $E_d$ is the built-in field, w is the width of depletion layer, $\mu$ is the time-domain response function for the carrier mobility (electrons and holes), $I_{OP}(t'')$ is the waveform of light pulses, $\tau_0$ is the relaxation time of light exciting carriers, and t' is the time during which light pulses are radiated.

The photo-Dember model making use of scattering of light exciting carriers was proposed by Dekorsy et. al in 1995 as an emission mechanism of a teraherz wave emitted from a Te surface (Non-Patent Document 3). Since a substance such as Te having a small band gap has a small surface electric field, a transient current effect resulting from the surface electric field cannot be expected as an emission mechanism of a terahertz wave.

Recently, it has been reported that a terahertz electromagnetic wave emitted from InAs and InSb surfaces is also emitted by the photo-Dember model. (Non-Patent Documents 8, 9).
Non-Patent Document 8:

L.M.B. Johnston, D.M. Whittaker, A. Corchia, A.G. Davies and E.H. Linfield, Phys. Rev. B65, 165301 (2002)

Non-Patent Document 9:

P. Gu, M,Tani, M. Kono, X.-C. Zhang and K. Sakai, J. Appl. Phys. 91, 5533 (2002)

In the Dember effect, a scattering current is generated by the difference between the scattering velocity of electrons and holes and an electric field (Dember electric field) is generated thereby. In general, since the scattering velocity of electrons is higher than that of holes, the spatial distribution of the electrons is made different from that of the holes by the difference between the scattering speeds of the electrons and the holes, from which the Dember electric field is generated. In particular, it is called the photo-Dember effect that the Dember electric field is generated by radiating light.

When a scattering current is generated by the photo-Dember effect in picosecond and subpicosecond regions, a terahertz electromagnetic wave is emitted in proportion to the time differential of the current. This is the photo-Dember model.

Fig. 4, which shows the photo-Dember model, is a schematic view showing the photo-Dember effect on a semiconductor surface.

The diffusive currents of the electrons ($J_n$) and holes ($J_p$) are described by the following equations.

[Equation 2]

$$J_n \sim -eD_e \frac{\partial \Delta n}{\partial x}$$

$$Jp \sim eD_h \frac{\partial \Delta p}{\partial x}$$

Here, e is the elecrton unit charge, $\Delta n$ and $\Delta p$ are the density of photocreated electrons and holes, $D_e$ and $D_h$ are the diffusion coefficient of electrons and holes.

[Equation 3]

$$D = \frac{k_B T_e}{e} \mu$$

Here, $k_B$ shows a Boltzmann constant, $T_e$ shows a carrier temperature, and $\mu$ shows a degree of migration.

According to the above equation, the scattering speed is made higher as the scattering coefficient is larger and the spatial distribution of carriers has a steeper gradient. Light exciting carriers Nex generated by light pulse excitation exhibits a distribution depending on the absorption coefficient ($\alpha$) of a substance.

$$Nex \propto \exp(-\alpha z)$$

GaAs having a relatively wide band gap has a penetration depth of 0.8 $\mu$m to 800 nm light, and further InAs having a relatively narrow band gap has an invasion length of 0.15 $\mu$m.

In general, since a substance with a narrower band gap has a smaller penetration depth to specific light, and the spatial distribution of the photo-excited carriers has a steeper gradient, the contribution of the photo-Dember effect is more increased.

In a steady state of a semiconductor surface, a drift current is in branch with a scattering current. The carriers created by light pulses are affected by both a drift motion due to a surface electric field and a scattering motion due to the ununiformity of the spatial distribution of carriers.

However, it is convenient to think that most of substances are dominantly contributed by any one of the motions and that a terahertz electromagnetic wave is emitted by the contribution of any one of the motions.

Since a semiconductor with a relatively large band gap has a large surface electric field, it is largely contributed by the transient current model making use of the surface electric field, whereas a semiconductor with a small band gap is largely contributed by the photo-Dember model.

A terahertz electromagnetic wave from coherent phonons was reported in Te by Dekorsy et al in 1995 for the first time (Non-Patent Document 10).

Non-Patent Document 10:

T. Dekorsy, H. Auer, C. Waschke, H.J. Bakker, H.G. Roskos, H. Kurz, V. Vagner, and P. Grosse, Phys. Rev. Lett. 74, 738 (1995)

Terahertz electromagnetic waves observed up to that time were only terahertz electromagnetic waves which corresponded to the change of time of a current caused by an ultrashort pulse laser in a state that a surface electric field or a direct current was applied to a specimen.

However, since the electromagnetic waves had a too small amount of coherence, it was difficult to use them as a monochromatic terahertz electromagnetic wave source.

In contrast, since a terahertz electromagnetic wave from coherent phonons is emitted as a terahertz electromagnetic wave corresponding to the eigenfrequency of coherent phonons, it is expected to emit a spectrally narrow terahertz wave.

Here, the terahertz electromagnetic wave emitted by the coherent phonons is different from lateral mode polaritons which transmit in the inside of a substance. Since polaritons do not generate macroscopic polarizations of a substance, no electromagnetic wave is emitted therefrom. The terahertz electromagnetic wave from the coherent phonons is observed in a field far from a substance externally thereof and made coherent by the collective motion of particles in the inside of an excited specimen. When the field is uniform, since the polarizations caused by the coherent phonons are cancelled with each other, no terahertz electromagnetic wave is emitted from coherent LO phonons. That is, since it is considered that polarizations are longitudinally oscillated in the inside of the specimen because of the breaking of the translational symmetry on a specimen surface.

Accordingly, when it is considered that a terahertz electromagnetic wave is emitted by the oscillation of a dipole in an excitation region, the terahertz electromagnetic wave can be handled as described below.

Since the electric field E(t) of an emitted electromagnetic wave relates to macroscopic polarizations, it relates to an electric field $E_{int}$(t) in a substance and is shown by the following equation (Non-Patent Document 11). That is, it is considered that a terahertz electromagnetic wave is emitted from coherent LO phonons because the electric field in a specimen changes as a time passes.

[Equation 4]

$$E(r, t + \frac{r}{c}) = \frac{\sin\phi}{\epsilon_\infty c^2} \frac{V}{r} \frac{d^2 E_{int}}{dt^2}$$

Here, $\phi$ shows an incident angle, V shows an emission volume, and r shows the distance from a specimen to a detector (Non-Patent Document 11).
Non-Patent Document 11:

A.V. Kuznetsov and C.J. Stanton, Phys, Rev, B51, 7555 (1995)

A result of experiment of the embodiment as to the emission of a terahertz electromagnetic wave from coherent longitudinal optical phonons in a GaAs/AlAs multiple quantum well will be described below.

A mainly used specimen was (GaAs)35/(AlAs)35 MQW with 50 periods epitaxially grown on a GaAs (100) surface substrate by an MBE method. Here, 35 means the number of monolayers in the constituent layers. For comparison, a GaAs thin film, which was epitaxially grown on a GaAs(100) surface substrate by the MBE method and a specimen of a (GaAs)35/(AlAs)35 MQW with 30 periods were used. In the following description, these specimens were called (35, 35)50 and MQW,(30, 30)30 MQW to discriminate the difference of periods.

A femtosecond pulse laser with a pulse width of about 40 fs was used as exciting light. A specimen temperature was changed from 20 K to 280 K, and excitation photon energy was changed from 1.485 eV to 1.570 eV.

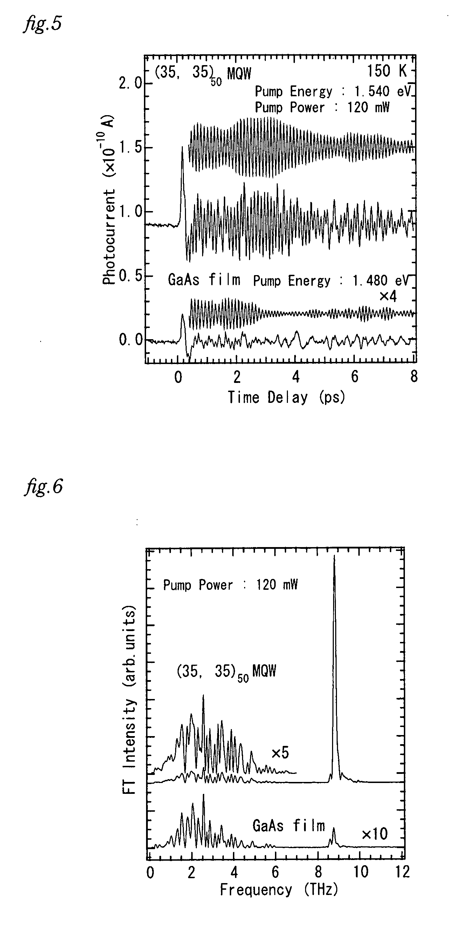

Fig. 5 shows time-domain signals of terahertz electromagnetic waves in the (35, 35)50 MQW and the GaAs thin film, and Fig. 6 shows the spectra by Fourier-transforming the time-domain signals of the terahertz electromagnetic waves.

Here, the specimen temperature was set to 150K. To industrially apply a terahertz electromagnetic wave from coherent phonons, a liquid nitrogen temperature or a temperature which can be achieved by a Peltier cooling device is required. In the embodiment, a terahertz electromagnetic wave was observed at a temperature of 150K sufficiently higher than the liquid nitrogen temperature of 77 K.

Exciting light intensity was set to 120 mW, and the exciting light energy in the (35, 35)50 MQW was tuned to 1.540eV which was the central energy between heavy hole (HH) and light hole (LH) excitons, and the excitation photon energy in the GaAs thin film was tuned to 1.485 eV which was the band gap energy of GaAs.

In any of the specimens, a signal having a large amplitude was observed in the vicinity of a time 0. A signal having a large amplitude as described above was often observed in the GaAs thin film up to now, and it was a transient current of a surface electric field generated by' the radiation of pump light or a terahertz electromagnetic wave generated by the drift current resulting from the photo-Dember effect.

Although it is considered that the terahertz electromagnetic wave having the amplitude in the vicinity of the time 0 in the (35, 35)50 MQW originated from a transient current in a GaAs substrate or a drift current generated by the Dember effect, actually, the signal has an intensity larger than that of the GaAs thin film. Accordingly, it is further considered that it also originated from the change of polarizations along the growth direction caused by an instantaneous quantum interference between HH, LH exitons in a GaAs quantum well layer.

Non-Patent Document 12 reports that the quantum interference of the HH, LH excions is instantaneously caused by exciting the well layers of a GaAs/AlAs multiple quantum well by a pulse laser, thereby instantaneous polarizations are caused along a growth direction (Non-Patent Document 12).
Non-Patent Document 12:

O. Kojima, K. Mizoguchi and M. Nakayama, Phys, Rev. B70, 233306 (2004)

Accordingly, it is considered that a terahertz electromagnetic wave is also emitted at the same time by the instantaneous quantum interference of exitons in a quantum well structure.

In contrast, in any of the specimens, a signal having a time cycle of about 110 fs was observed following to the large terahertz electromagnetic wave in the vicinity of the time 0. Since the signal agrees with the cycle estimated by the LO phonons energy of GaAs, the oscillation structure is constructed by coherent GaAs-like LO phonons.

When the intensities of the electromagnetic waves of the two specimens from the coherent LO phonons are compared with each other, the signal in the (35, 35)50 MQW has amplitude about 10 times larger than that of the terahertz electromagnetic wave in the GaAs thin film and also has a longer dephasing time.

That is, in the quantum well structure, a very intensive terahertz electromagnetic wave having a long coherent time was observed. The feature that the coherent time is long shows a tendency similar to that of the coherent LO phonons, which was observed up to now, confined in quantum well layers (Non-Patent Document 13).
Non-Patent Document 13:

H. Takeuchi, K. Mizoguchi, M. Nakayama, K. Kuroyanagi, T. Aida, M. Nakajima and H. Harima, J. Phys. Soc. Jpn. 70, 2598 (2001)

The terahertz electromagnetic wave from the coherent LO phonons in the GaAs thin film does not exhibit a simple exponential decay, increases in the vicinity of 2 ps, and thereafter decreases. Non-Patent Document 6 reports that since the group velocity of phonon-polariton depends on a frequency, a frequency component near to a reststralen band is accumulated in a substance once before it is emitted.

Accordingly, it is considered that the terahertz electromagnetic wave from the coherent LO phonons is observed with a time lag.

The signal in the (35, 35)50 MQW does not decay exponentially likewise and has a peak amplitude in the vicinity of 3 ps. Thereafter, the amplitude of the signal increases again in the vicinity of 6 ps. It is considered that the peak of the signal is delayed by the same reason as the GaAs thin film. The fact that the signal increases again will originate from that the terahertz electromagnetic wave which transmits in the specimen is reflected on the back surface of the GaAs substrate and emitted again.

As shown in Fig. 6, a broad band is observed in a [0 - 7 THz] region in any of the FT spectra. This is a signal originated from a transient photocurrent in the vicinity of the time 0.

A band larger than that in the GaAs thin film is observed in the (35, 35)50 MQW. It is considered that this is caused by the change of polarizations due to the instantaneous quantum interference between the HH and LH excitons in the quantum well layer. Note that a lot of dips in the broad band is caused by absorption of water-vapor in air.

Further, although a peak is observed in the vicinity of 8.8 THz in any of the specimens, the intensity of the peak in the (35, 35)50 MQW was 100 times larger than that in the GaAs thin film, and an FT band width shows a sharp shape. This exhibits that the coherence of the terahertz electromagnetic wave from the coherent LO phonons confined in the quantum well layer is very high.

Here, the band observed in the vicinity of [0 - 7 THz] is extended up to a wide band as compared with the FT band of the terahertz electromagnetic wave from the GaAs surface reported up to the present. It is suggested that this feature is caused by LO phonon-plasmon coupled mode.

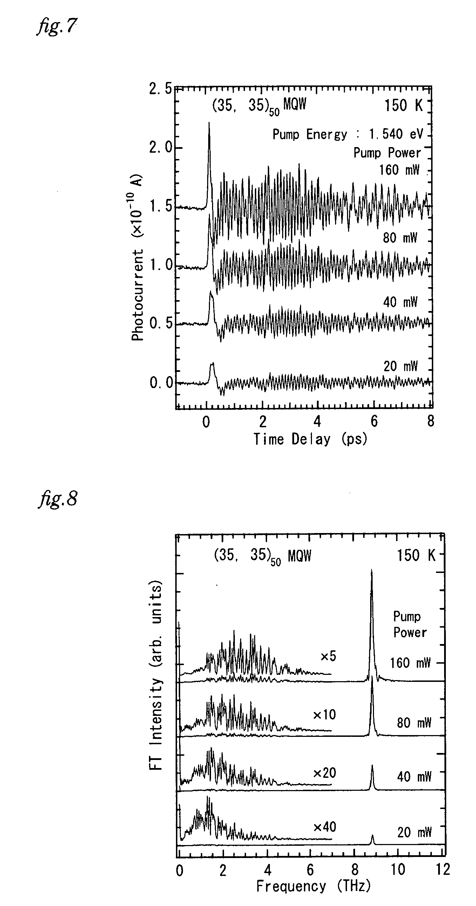

Thus, exciting light intensity dependence was measured in the (35, 35)50 MQW. Fig. 7 is a graph showing the signals of terahertz electromagnetic waves when excitation power is changed in the (35, 35)50 MQW, and Fig. 8 is a graph showing the FT spectra of them.

Both the signals of the terahertz electromagnetic waves in the vicinity of the time 0 and the signals of the terahertz electromagnetic waves from the coherent LO phonons are greatly changed by the excitation power. The signals in the vicinity of the time 0 are made sharp as the excitation power increases.

As apparent from the band in the vicinity of [0 - 7 THz] of Fig. 8, when the exciting light intensity is increased, the broadened band shifts to a high oscillation frequency side.

The broad tail at the higher frequency side of the LO-phonon band appears under the high excitation power. The broad tail spreads toward the high frequency side as the excitation power is increased.

Since this behavior exhibits a feature observed in the the LO phonon-plasmon coupled mode, it is considered that a plasmon-LO phonon coupled mode is observed also in the embodiment (Non-Patent Document 14).
Non-Patent Document 14:

G.C. Cho, T. Dekorsy, H.J. Bakker, R. Hovel and H.Kurz, Phys. Rev. Lett. 77, 4062 (1996)

Next, an excitation energy dependence was investigated in the (35, 35)50 MQW to confirm that the terahertz electromagnetic wave from coherent LO phonons observed in the (35, 35) 50 MQW is the terahertz electromagnetic waves from GaAs-like LO phonons confined in a quantum well layers.

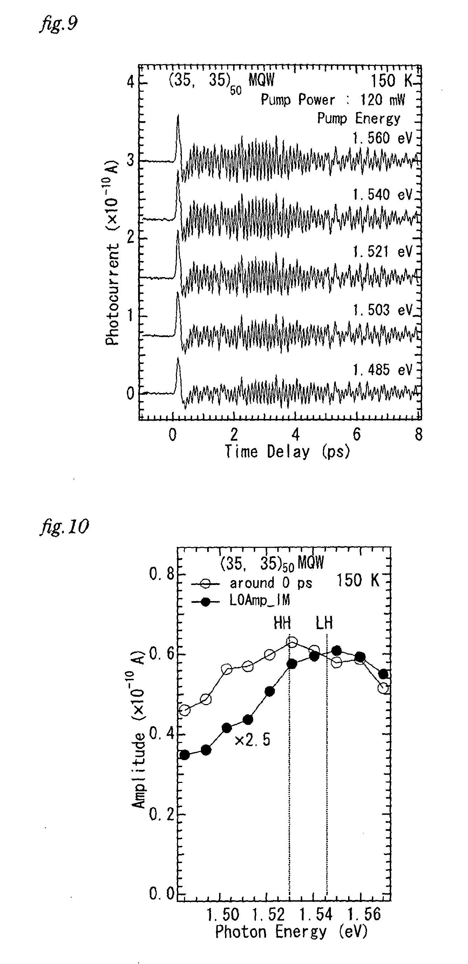

Figs. 9 and 10 show a result of the excitation energy dependence of the terahertz electromagnetic wave, wherein Fig. 9 is a graph showing the terahertz electromagnetic waves when the excitation energy is changed in the (35, 35) 50 MQW, and Fig. 10 is a graph showing the excitation energy dependance of the maximum amplitudes of the terahertz electromagnetic waves from the coherent LO phonons. A plot O shows a response of transient photocarriers, and a plot ● shows amplitude intensity of coherent GaAs-like LO phonons.

The intensity of the terahertz electromagnetic waves is changed with the excitation energy, and, in particular, the intensity of the terahertz electromagnetic wave from the coherent LO phonons are prominently changed in response to the change of the excitation energy.

As apparent from Fig. 10, the terahertz electromagnetic waves are resonantly enhanced in the vicinity of the HH and LH exciton energies. This result exhibits that the terahertz electromagnetic waves emitted from the quantum well structure are the coherent GaAs-like LO phonons confined in the well layer.

In the multiple quantum well structure, the terahertz electromagnetic waves from the coherent LO phonons are enhanced by the following mechanism. In the GaAs thin film, the terahertz electromagnetic waves from the coherent LO phonons are emitted by the breaking of the translational symmetry of the coherent LO phonons on a specimen surface. Accordingly, the emitting region of the terahertz electromagnetic waves in the GaAs thin film is limited to the vicinity of the sample surface and has a weak intensity. In contrast, in a GaAs/AlAs multiple quantum well structure, GaAs-like LO phonons exist only in a GaAs well layer and have a $B_2$ symmetry (Non-Patent Document 15). Non-Patent Document 15:

P.Y. Yu and M. Cardona, in Fundamentals of Semiconductors, (Springer-Verlag, Berlin, 1996), Chap, 9

The GaAs-like LO phonons having a lowest mode (number of order: m=1) in the confined GaAs-like LO phonons having the $B_2$ symmetry generate oscillatory polarization in the well layer. Accordingly, the coherent GaAs-like LO phonons in the GaAs well layers oscillate in-phase, and if a minute polarization $p_i$ is generated in the respective well layers, it is considered that a macroscopic polarization in the multiple quantum well structure is the sum of the minute polarizations in the GaAs well layer.

[Equation 5]

$$P = \sum_{i}^{n} p_i \qquad (i = 1, 2, ..)$$

Here, n shows the number of well layers.

Accordingly, if the terahertz electromagnetic waves from the coherent GaAs-like LO phonons are generated as the superposition of the polarizations in the respective well layers, it is considered that the intensity of the terahertz electromagnetic waves depends on the number of the constituent well layers. That is, it is predicted that when the period number of the layer increases, the terahertz electromagnetic waves from the coherent GaAs-like LO phonons also increase. The terahertz electromagnetic waves were measured using specimens having different period numbers based on the above prediction.

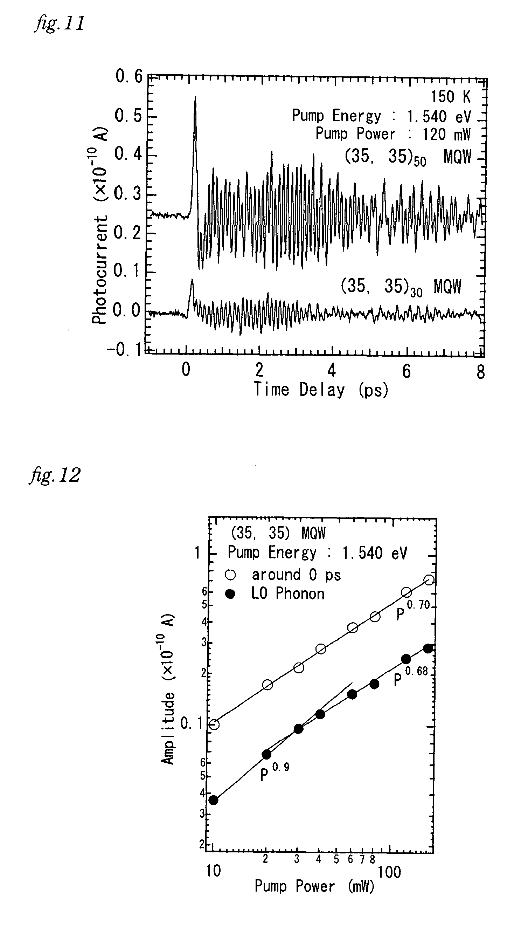

Fig. 11, which shows the comparison between the intensities of terahertz electromagnetic waves from coherent GaAs-like LO phonons in specimens having different period numbers, is a graph showing the signals of terahertz electromagnetic waves obtained in the (35, 35)50 MQW and a (35, 35)30 MQW.

It was observed that a terahertz electromagnetic wave from a specimen having 50 periods is about three times more intense than that obtained from a specimen having 30 periods. This result suggests that the terahertz electromagnetic wave is enhanced in the multiple quantum well structure by the polarizations superposed by the coherent GaAs-like LO phonons in the respective GaAs well layers.

Fig. 12 is a graph showing the amplitudes of the signals in Fig. 7 when they are plotted as the function of excitation power. In Fig. 12, O shows a signal in the vicinity of the time 0, and ● shows the amplitude of the signal of a terahertz electromagnetic wave from coherent GaAs-like LO phonons. A solid line shows a fitted curve obtained by a least-square method.

When a mechanism for generating coherent phonons is a conventionally proposed DECP or ISRS mechanism, it is assumed that the amplitude of coherent phonons is linearly increased with the excitation power. According to Fig. 12, the amplitude of a signal in the vicinity of the time 0 is increased with the 0.7 power of excitation power. It is considered that the amplitude of a terahertz electromagnetic wave from a surface of a specimen having no quantum well structure is proportional to excitation power, and a result approximately agrees with the above case, although it exhibits a saturating tendency.

Further, the intensity of the signal of the terahertz electromagnetic wave from the coherent LO phonons is increased with the 0.9 power of excitation power, which shows almost the linear dependence on excitation power under a low excitation power region. However, as excitation power increases, the signal intensity is increased with the 0.68 power of excitation power and thus exhibits a saturating tendency.

It is considered that the result exhibits the above saturating tendency because as the exciting density is increased, the signal is affected by scattering due to carriers or Coulomb screening.

Next, the excitation power dependence was investigated again by reducing the excitation energy by 60 meV from the excitation energy. It is considered that the generation of exitons in the quantum well layer is suppressed by detuning the excitation energy away from the exciton energy and that the signal is less affected by the scattering due to the carrier or the Coulomb screening.

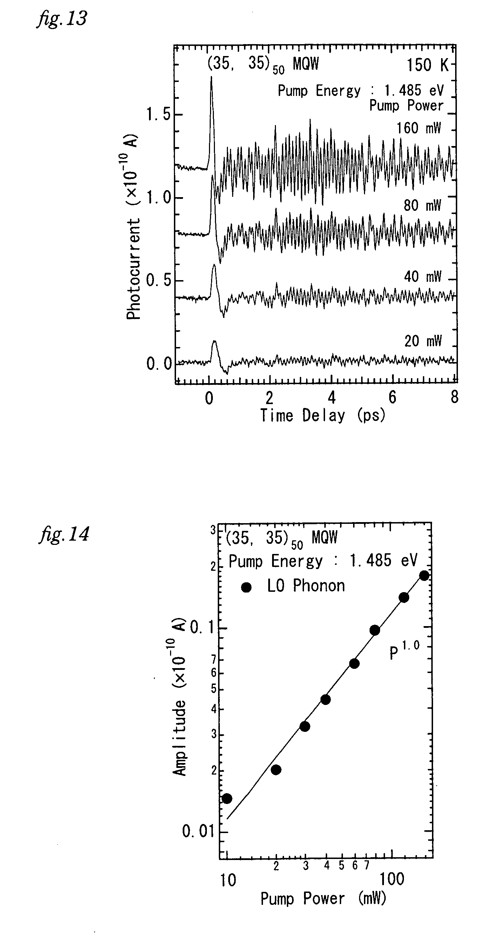

Figs. 13 and 14 show a result of measurement of the excitation power dependence of the terahertz electromagnetic wave observed in the (35, 35)50 MQW while tuning the excitation energy to 1.485 eV, wherein Fig. 13 is a graph showing the signal of an emitted terahertz electromagnetic wave, and Fig. 14 is a graph in which the respective amplitudes of the terahertz electromagnetic waves are plotted as the function of excitation power. In Fig. 14, ● shows the amplitude intensity of coherent GaAs-like LO phonons, and a solid line shows the fitted result obtained by a least-square method.

The signal amplitude of coherent LO phonons is linearly increased with the excitation power. This result exhibits that the generation mechanism of the coherent LO phonons is the DECP or ISRS mechanism.

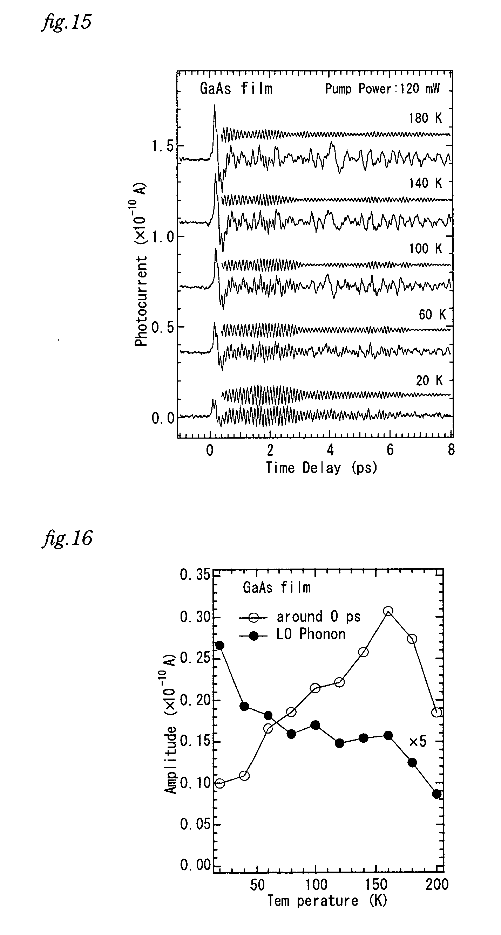

Fig. 15 is a graph showing the temperature dependence of the terahertz electromagnetic wave observed in the GaAs thin film. In Fig: 15, excitation energy is tuned to the energy by 10 meV higher than GaAs band gap energy at respective temperatures, and the signals shown in Fig. 15 are signals from which a background, which is changed by the vapor absorption of the signal of 0.4 ps and subsequent signals, is numerically subtracted. Fig. 16 is a graph showing the amplitudes plotted at the respective temperatures, wherein ○ shows a signal in the vicinity of the time 0, and ● shows the maximum frequency amplitude the signal of coherent GaAs-like LO phonons.

The amplitude of the signal of the coherent GaAs-like LO phonons is decreased as a temperature increases, and further dephasing time thereof is shortened. This exhibits a behavior similar to the temperature dependence of coherent phonons reported heretofore by a reflection type pump-probe method (Non-Patent Document 16).
Non-Patent Document 16:

M. Hase, K. Mizoguchi, H. Harima, S. Nakashima and K. Sakai,Phys. Rev. B58, 5448 (1998)

It is considered that this behavior is exhibited because as a temperature increases the generation efficiency of the coherent LO phonon is lowered by the influence of thermal phonons and thus coherence cannot be maintained. In contrast, the intensity of the signal in the vicinity of the time 0 is increased as a temperature increases. This result exhibits a behavior different from the temperature dependence of a terahertz electromagnetic wave from the surface of the GaAs disclosed in Non-Patent Document 17 (Non-Patent Document 17).
Non-Patent Document 17:

B.B. Hu, X.-C. Zhang and D.H. Auston, Appl, Phys. Lett. 57, 2629 (1990)

That is, Non-Patent Document 17 reports that since the degree of migration of carriers are lowered as a temperature increases, the intensity of an emitted terahertz electromagnetic wave is reduced. However, this phenomenon is not observed in the result of the experiment.

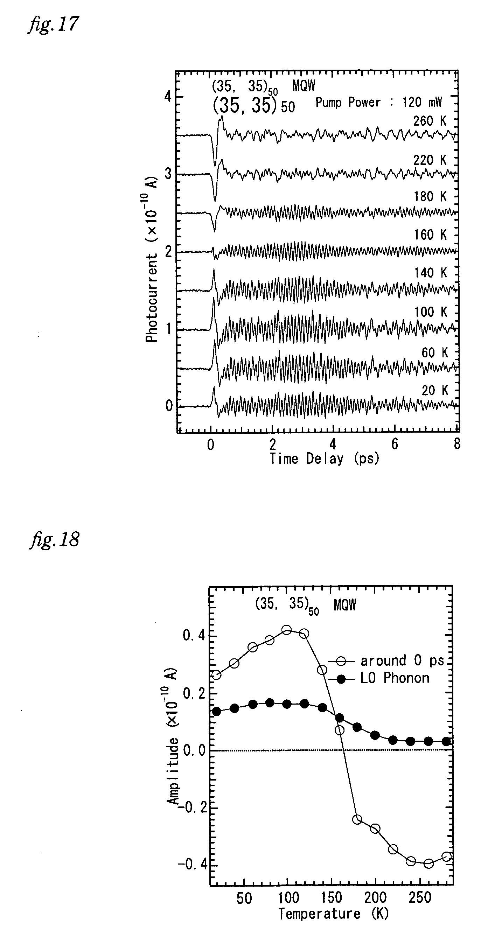

Fig. 17 is a graph showing the temperature dependence of the terahertz electromagnetic waves observed in the (35, 35)50 MQW. In Fig. 17, the excitation energy is tuned to the central energy between the HH and LH excitations at respective temperatures, and the excitation power was set to 120 mW. When a temperature is changed, the signal of the terahertz electromagnetic wave in the vicinity of the time 0 becomes extremely small at 160K although it dose not exhibits a significant change up to about 140K. Further, the sign of the signal was inverted at a temperature higher than 180K. Although the signal from the coherent LO phonons dose not exhibit a significant change up to about 140K, the intensity of the signal is gradually reduced at a temperature higher than 180K, and further the dephasing time of the signal is shortened.

Fig. 18 is a graph in which the amplitudes of the terahertz electromagnetic waves are plotted as a function of temperature, wherein ○ shows signal in the vicinity of the time 0, and ● shows the maximum amplitude of the amplitude intensity of the signal of coherent GaAs-like LO phonons.

It is considered that the signal of the coherent phonons cannot maintain coherence because as a temperature increases, the efficiency for generating coherent LO phonons is lowered by the influence of thermal phonons. When the signal is compared with the signal in GaAs thin film, although the temperature dependence of the amplitude exhibits approximately the same tendency as that in the GaAs thin film, a long dephasing time is maintained up to a high temperatures as compared with that in the GaAs. The result that the coherence can be maintained up to the high temperature may be due to the suppression of the scattering process of coherent LO phonons because the coherent LO phonons in the quantum well state is confined in the well layer.

In contrast, the intensity of the signal in the vicinity of the time 0 is increased as the temperature increases, forms a peak once at 120K, thereafter decreases abruptly, and the sign of the signal is inverted. The inversion of the sign described above is similar to the phenomenon reported in InP (Non-Patent Document 18).

Non-Patent Document 18:

M. Nakajima, M. Takahashi and M. Hangyo, J. Lumin, 94-95, 627 (2001)

In a p-type semiconductor, the drift current $J_{drift}$ of the transient current model generated in the surface electric field has a direction opposite to that of the scattering current $J_{diffusion}$ of the photo-Dember model. Accordingly, a dominant emission mechanism of a prevailing terahertz electromagnetic wave is changed when a temperature changes, the sign of an observed electromagnetic wave is inverted.

In contrast, it is considered that the terahertz electromagnetic wave from the surface is mainly generated from the GaAs substrate. It is known that the potential structure of a GaAs surface ordinarily has an n-type. However, it can be considered that some sort of change is caused to the potential structure by growing the quantum well structure on the GaAs substrate and thus the potential structure in the interface between the quantum well structure and the GaAs substrate is made to a p-type.

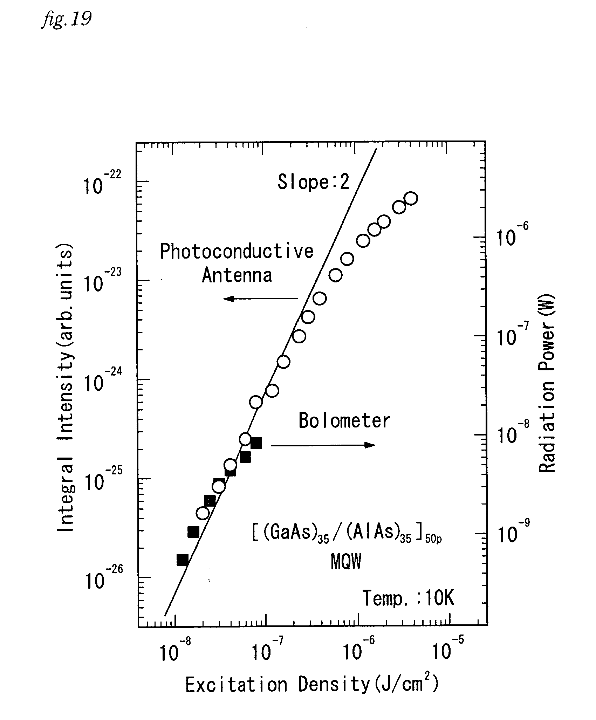

Fig. 19 is a graph showing the radiation power of the terahertz electromagnetic wave observed in the (35, 35) 50 MQW.

As described above, according to the present invention, an emission of 2 µW can be obtained by the excitation power of 200 mW. As a result, the present invention can obtain a value in terms of efficiency at least 10 times as large as that of the emission of a terahertz wave from the surface of semiconductor InAs.

INDUSTRIAL APPLICABILITY

According to the present invention, it is possible to effectively generate a terahertz electromagnetic wave having an high intensity from coherent phonons even at a relatively high temperature by an resonant enhancement. In, for example, a GaAs/AlAs multiple quantum well structure, the intensity of an electromagnetic wave emitted from coherent phonons can be increased to about 100 times that from GaAs epitaxial film. Therefore, the terahertz electromagnetic wave generated by the present invention is useful as a light source in various sensing systems, an electromagnetic wave for communication, and so on, and thus the present invention is very valuable in industries.

**Claims**

1.  A method for generating a terahertz electromagnetic wave by using coherent phonons in a quantum structure, **characterized by** obtaining high density of coherent phonons acting as a radiation source of the terahertz electromagnetic wave under the condition that the energy difference between two inter-band transitions is resonated with the energy of the coherent phonons and the energy of the pulse laser is tuned to the inter-band transitions in the quantum structure, and by generating the terahertz electromagnetic wave caused by the oscillatory polarizations of the coherent confined LO phonons.

2.  A method for generating a terahertz electromagnetic wave by using coherent phonons according to claim 1, wherein the coherent phonons are created through elementary excitation generated by using instantaneous laser pulses under the condition that the energy difference between two inter-band transitions in the quantum structure is resonated with the energy of the coherent phonons.

3.  A method for generating a terahertz electromagnetic wave by using coherent phonons according to claim 1 or 2, wherein:

    the quantum structure is a quantum well structure; and

a scattering process of coherent phonon is suppressed by confining coherent LO phonons in a well layer.

4. A method for generating a terahertz electromagnetic wave by using coherent phonons according to claims 1 to 3, wherein heavy hole (HH) and light hole (LH) excitons are created simultaneously, and the difference of energies between HH and LH excitons is caused to agree with the energy of the LO phonons.

5. A method for generating a terahertz electromagnetic wave by using coherent phonons according to claims 1 to 4, wherein the quantum structure is a single quantum well.

6. A method for generating a terahertz electromagnetic wave by using coherent phonons according to claims 1 to 4, wherein the quantum structure is a multiple quantum well.

7. A method for generating a terahertz electromagnetic wave by using coherent phonons according to claims 1 to 4, wherein the quantum structure is a superlattice.

8. A method for generating a terahertz electromagnetic wave by using coherent phonons according to claims 1 to 4, wherein the quantum structure is a self-forming quantum dot.

9. A method for generating a terahertz electromagnetic wave by using coherent phonons according to claims 1 to 8, wherein the quantum structure comprises a semiconductor.

10. A method for generating a terahertz electromagnetic wave by using coherent phonons according to claim 9, wherein the semiconductor of the quantum structure is GaAs/AlAs multiple quantum well structure of self-forming quantum dot.

11. A method for generating a terahertz electromagnetic wave by using coherent phonons according to claim 10, wherein the semiconductor GaAs/AlAs multiple quantum well structure comprises about 50 cycles of (GaAs)35/(AlAs)35 components (35 means the number of constituted atom layers).

12. A method for generating a terahertz electromagnetic wave by using coherent phonons according to claim 11, wherein the about 50 cycles of the (GaAs)35/(AlAs)35 components are epitaxially grown on a GaAs (100) substrate.

13. A method for generating a terahertz electromagnetic wave by using coherent phonons according to claims 1 to 8, wherein the quantum structure comprises dielectric.

14. A method for generating a terahertz electromagnetic wave by using coherent phonons according to claims 1 to 8, wherein the quantum structure comprises semi-metal.

15. A method for generating a terahertz electromagnetic wave by using coherent phonons according to claims 1 to 8, wherein the quantum structure comprises an organic substance.

*fig.1*

Surface $E_{surface}$

$\varepsilon_{surface}$

$E_c$

$\varepsilon_{Fe}$

$\phi$

$E_v$

Depletion Layer

*fig.2*

Surface $E_{surface}$

$E_c$

$\varepsilon_{Fe}$

$\varepsilon_{surface}$

$\phi$

$E_v$

Depletion Layer

*fig.3*

*fig.4*

*fig.5*

*fig.6*

fig.7

fig.8

*fig.9*

*fig.10*

*fig.11*

*fig.12*

*fig.13*

*fig.14*

fig.15

fig.16

fig.17

fig.18

fig.19

## INTERNATIONAL SEARCH REPORT

| | International application No. |
|---|---|
| | PCT/JP2006/304077 |

**A. CLASSIFICATION OF SUBJECT MATTER**
*G02F2/02*(2006.01), *H01S1/02*(2006.01)

According to International Patent Classification (IPC) or to both national classification and IPC

**B. FIELDS SEARCHED**

Minimum documentation searched (classification system followed by classification symbols)
*G02F2/00*(2006.01), *G02F1/00*(2006.01), *H01S1/02*(2006.01), *H01S3/10*(2006.01)

Documentation searched other than minimum documentation to the extent that such documents are included in the fields searched
Jitsuyo Shinan Koho          1922-1996     Jitsuyo Shinan Toroku Koho    1996-2006
Kokai Jitsuyo Shinan Koho    1971-2006     Toroku Jitsuyo Shinan Koho    1994-2006

Electronic data base consulted during the international search (name of data base and, where practicable, search terms used)
INSPEC(DIALOG), JSTPlus(JDream2),
Science Citation Index Expanded(Web of Science)

**C. DOCUMENTS CONSIDERED TO BE RELEVANT**

| Category* | Citation of document, with indication, where appropriate, of the relevant passages | Relevant to claim No. |
|---|---|---|
| P,X | Mizoguchi, K. et al., Intense terahertz radiation from longitudinal optical phonons in GaAs/AlAs multiple quantum wells, Applied Physics Letters, Vol.87, No.9, (August 2005), p.093102-1-3 | 1-12 |
| A | Kuznetsov, A.V. Stanton, C.J. Coherent phonon oscillation in GaAs, Physical Review B, Vol.51, No.12, (March 1995), pages 7555 to 7565 | 1-15 |

☐ Further documents are listed in the continuation of Box C.          ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 15 May, 2006 (15.05.06) | 23 May, 2006 (23.05.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

# EP 1 855 156 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P.R. SMITH ; D.H. AUSTON.** *IEEE J. Quantum Electron.,* 1988, vol. 24, 255
- **X.-C. ZHANG ; B.B. HU ; J.T. DARROW ; D.H. AUSTON.** *Appl. Phys. Lett.,* 1990, vol. 56, 1011
- **T.DEKORSY ; H. AUER ; H.J. BAKKER ; H.G. ROSKOS ; H. KURZ.** *Phys. Rev. B,* 1996, vol. 53, 4005
- **M. TANI ; R. FUKASAWA ; H. ABE ; S. MATSUURA ; S.NAKASHIMA ; K. SAKAI.** *J. Appl. Phys.,* 1998, vol. 83, 2473
- **A. LEITENSTORFER ; S.HUNSCHE ; J. SHAH ; M.C. NUSS ; W.H. KNOX.** *Phys. Rev. Lett.,* 1999, vol. 82, 5140
- **Y.C. SHEN ; P.C. UPADHYA ; H.E. BEERE ; A.G. DAVIES ; I.S, GREGORY ; C. BAKER ; W.R. TRIBE ; M.J. EVANS ; E. H. LINFIELD.** *Appl. Phys. Lett.,* 2004, vol. 85, 164
- **X.-C. ZHANG ; D.H. AUSTON.** *J. Appl. Phys.,* 1992, vol. 71, 326
- **L.M.B. JOHNSTON ; D.M. WHITTAKER ; A. CORCHIA ; A.G. DAVIES ; E.H. LINFIELD.** *Phys. Rev. B,* 2002, vol. 65, 165301
- **P. GU ; M,TANI ; M. KONO ; X.-C. ZHANG ; K. SAKAI.** *J. Appl. Phys.,* 2002, vol. 91, 5533
- **T. DEKORSY ; H. AUER ; C. WASCHKE ; H.J. BAKKER ; H.G. ROSKOS ; H. KURZ ; V. VAGNER ; P. GROSSE.** *Phys. Rev. Lett.,* 1995, vol. 74, 738
- **A.V. KUZNETSOV ; C.J. STANTON.** *Phys, Rev,* 1995, vol. B51, 7555
- **O. KOJIMA ; K. MIZOGUCHI ; M. NAKAYAMA.** *Phys, Rev.,* 2004, vol. B70, 233306
- **H. TAKEUCHI ; K. MIZOGUCHI ; M.NAKAYAMA ; K. KUROYANAGI ; T. AIDA ; M. NAKAJIMA ; H. HARIMA.** *J. Phys. Soc. Jpn.,* 2001, vol. 70, 2598
- **G.C. CHO ; T. DEKORSY ; H.J. BAKKER ; R. HOVEL ; H.KURZ.** *Phys. Rev. Lett.,* 1996, vol. 77, 4062
- **P.Y. YU ; M. CARDONA.** Fundamentals of Semiconductors. Springer-Verlag, 1996
- **M. HASE ; K. MIZOGUCHI ; H. HARIMA ; S. NAKASHIMA ; K. SAKAI.** *Phys. Rev. B,* 1998, vol. 58, 5448
- **B.B. HU ; X.-C. ZHANG ; D.H. AUSTON.** *Appl, Phys. Lett.,* 1990, vol. 57, 2629
- **M. NAKAJIMA ; M. TAKAHASHI ; M. HANGYO.** *J. Lumin,* 2001, vol. 94-95, 627